# EUROPEAN PATENT APPLICATION

(11) **EP 0 896 968 A1**
(43) Date of publication of application: **17.02.1999**
(21) Application number: 98902265.2
(22) Date of filing: 17.02.1998
(51) Int. Cl.: C08F 8/14, C08F 2/46, C08F 290/12, B01J 31/24, G03F 7/027, G02B 1/04, G02B 5/30

(54) **MODIFIED COPOLYMER, PROCESS FOR PREPARING THE SAME, AND CURABLE RESIN COMPOSITION**

(30) Priority: 17.02.1997 JP 48502/97; 17.02.1997 JP 48504/97; 19.02.1997 JP 50978/97; 19.02.1997 JP 50979/97
(71) Applicant: DAICEL CHEMICAL INDUSTRIES, Ltd., Sakai-shi, Osaka 590-0905 (JP)
(72) Inventor: TANIGAWA, Hiroto, Hiroshima 739-0651 (JP); MIYAKE, Hiroto, Hiroshima 739-0651 (JP); NAGAKAWA, Ichiro, Hiroshima 739-0651 (JP)
(74) Representative: Portal, Gérard
(86) International application number: JP9800658
(87) International publication number: WO9836000

(57) **Abstract**

The first aspect of the present invention is a curable resin characterized by an acid value of not more than 20 KOH mg/g, which is obtained by addition of an epoxy group-containing unsaturated compound (c) having an alicyclic structure to carboxylic groups in a copolymer of a copolymerizable unsaturated carboxylic acid (a) with an unsaturated compound (b) other than the unsaturated carboxylic acid, and it is a novel curable resin having an excellent weatherability.

The second aspect of the present invention is a process for the preparation of a modified copolymer characterized in that a copolymer having carboxylic groups is obtained by copolymerization of a copolymerizable unsaturated carboxylic acid (a) with an unsaturated compound (b) other than the unsaturated carboxylic acid, and then, an epoxy group-containing unsaturated compound (c) is added to the carboxylic groups in the copolymer using a phosphine compound represented by general formula (II-1) described below as a catalyst for addition reaction, 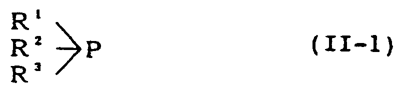 (in the formula, R¹ represents a phenyl group having an alkyl group or an alkoxy group, a linear or branched alkyl group or cycloalkoxy group, R² and R³ represent a phenyl group which may have an alkyl group or alkoxy group, a linear or branched alkyl group or cycloalkyl group, and R¹, R², and R³ may he all different or identical, respectively), and in which a reaction efficiency can be elevated by employing a phosphine compound having a specified structure as a catalyst for an addition reaction.

The third aspect of the present invention is a curable resin composition characterized by comprising the (A), (B), and (C) described below, and it does not substantially contain organic solvents,
(A) a modified copolymer in which an epoxy group-containing unsaturated compound (c) having an alicyclic structure is added to carboxyl groups in a copolymer of a copolymerizable unsaturated carboxylic acid (a) with an unsaturated compound (b) other than the unsaturated carboxylic acid,
(B) a reactive diluent having at least one (meth)acrylic groups, and,
(C) a polymerization initiator.

The fourth aspect of the present invention is a modified copolymer in which an epoxy group-containing unsaturated compound (d') is added to carboxyl groups in a copolymer of a compound (a') having an unsaturated group and at least one carboxyl groups with a compound (b') having an unsaturated group, and there can be obtained a radiation-curable resin composition by which an image pattern can be formed by exposing to a ray and by developing with a diluted aqueous alkali solution after forming a coating layer, and a molded article therefrom.

## Description

### TECHNICAL FIELD

First aspect of the present invention relates to a modified copolymer which is a curable resin, and it relates to a novel curable resin having an excellent weatherability.

Second aspect of the present invention relates to a process for the preparation of a modified copolymer and, in more detail, it relates to a process for the preparation of a modified copolymer in which a phosphine compound having a specified structure is employed as a catalyst for addition reaction, and, whereby, efficiency in the reaction is elevated.

Third aspect of the present invention relates to a curable resin composition and, in more detail, it relates to a novel curable resin composition characterized by not substantially containing organic solvents.

Forth aspect of the present invention relates to a modified copolymer containing an ultraviolet ray-absorbable group, a radiation-curable resin composition containing the modified copolymer, and a molded article therefrom, and it relates to a radiation-curable resin composition in which image patterns can be formed by photo-exposure and developing through a diluted aqueous alkali solution after forming a layer.

### BACKGROUND ART

First of all, there are illustrated the first, second, and third aspects of the present invention.

With remarkable progress of polymer industries, there have been employed a great variety of polymeric materials over a wide scope. In recent years, there has been particularly pushed forward a development of more excellent polymeric materials with the progress of a shift to high function and performance in industrial products.

Of the materials, reactive oligomers or polymers having a plurality of double bonds in the molecule have a wide range of industrial uses as thermosetting resins and photo-curable resins and, further, as other reactive resins, and there have been pushed forward developments in a variety of fields.

Of those, copolymers having carbon-carbon double bonds as side chains are more excellent in weatherability and adhesive properties, etc. compared to a curable resin such as an unsaturated polyester resin having carbon-carbon double bonds and ester bonds in a main chain, whereby, uses thereof are being enlarged. Particularly, a resin having alicyclic structures in side chains is excellent in weatherability, whereby, it is important as constructing components in a variety of coatings, inks, and adhesives, etc.

The copolymers having carbon-carbon double bonds as side chains can be prepared by addition of a compound having a double bond which is a compound for side chains to functional groups in a copolymer not having carbon-carbon double bonds as side chains.

Regarding the first and second aspects of the present invention, for example, JP-A-01289820 and JP-A-06138659 Official Gazettes disclose a method for the preparation of a curable resin by addition of a compound having a carbon-carbon double bond and an epoxy group to a copolymer having carboxylic groups which becomes a main chain. By the method, a variety of compounds which become side chains can be added to the copolymer which becomes main chains, and the preparation is easy and exceedingly excellent in view of a large degree of freedom in a design of resins, whereby, it is a method which is recently watched.

Regarding the third aspect of the present invention, for example, JP-A-06019135 official Gazette discloses a method for the preparation by addition of a compound having an epoxy group and a carbon-carbon double bond to a copolymer having carboxylic groups as side chains. By the method, the preparation is easy and exceedingly excellent in view of a large degree of freedom in a design of resins, whereby, it is a method which is recently watched. On the other hand, in recent, from a viewpoint of prevention of atmospheric pollution and an improvement of working circumstances, there have been investigated a shift to high solid in a composition for employing in uses for a variety of coatings, inks, and adhesives and a shift to no solvents. For that reason, as monomers, oligomer, and resins of which a composition is composed, there are often employed a polyester acrylate, an epoxy acrylate, and a urethane acrylate, and the like.

Hereinafter, there is illustrated the fourth aspect of the present invention.

In a synthetic resin composition, photo-absorbable functional groups contained in the resin composition are exited by an ultraviolet ray, and there is a resin deteriorated by energy produced thereby. In order to prevent the deterioration by irradiation of the ultraviolet ray, there is carried out the addition of an ultraviolet ray absorbable compound having a low molecular weight which can reduce the exiting into a synthetic resin composition. Although the ultraviolet ray absorbable compound having a low molecular weight is effective in order to suppress and retard the deterioration of the synthetic resin composition, it is limited in uses because of occasionally causing a bleeding. Further, in the case that the synthetic resin composition is exposed to high temperature in treatment or molding process, there evaporates the ultraviolet ray absorbable compound having a low molecular weight, resulting in that a sufficient effect for suppressing cannot be occasionally obtained.

In order to solve the problems, JP-A-05271203 Official Gazette discloses a monomer which is copolymerizable with other monomers, which is a compound containing an ultraviolet ray-absorbable portion which is possessed by an ultraviolet ray absorbent in the structure. The monomer is hydroxybenzophenones, 2-hydroxy-5-acryloyloxyalkylphenyl-2H-benzotriazoles, and the like, which are copolymerizable with an acrylate, and which effectively absorb ultraviolet ray and, further, which can form a stable copolymer. Accordingly, it is thought that the deterioration by an ultraviolet ray in the synthetic resin composition can be prevented by mixing the monomers with copolymerizing components in the synthetic resin composition.

Hereinafter, there is illustrated a purpose of the first to fourth aspects of the present invention.

Regarding the first aspect of the present invention, although a variety of curable resins have been proposed until now, there has been still desired a further improvement in weatherability.

Regarding the second aspect of the present invention, in a process for the preparation of the modified copolymer by the above-described addition reaction, since a certain extent of time is required for the addition reaction, there has been desired a development of a technology by which reaction efficiency becomes excellent and cost saving is attained.

Regarding the third aspect of the present invention, in a many resin composition comprising a polyester acrylate or an epoxy acrylate, adhesion to a substrate is insufficient and, in a many resin composition comprising a urethane acrylate, weatherability is insufficient. From the above-described viewpoint, there has been desired a development of a curable resin composition which does not substantially contain organic solvents and has an excellent adhesion and weatherability.

Regarding the fourth aspect of the present invention, it is as follows. In the case that the synthetic resin composition is employed in uses for coatings, properties become important in the synthetic resin composition itself. Accordingly, if the synthetic resin composition itself is not excellent in adhesion to a substrate, weatherability, and an anti-staining property, even though it is durable against an ultraviolet ray, it is not regarded that it is appropriate as uses for coatings. Further, in the case that it is employed as a photo-resist or a liquid-state resist, there is required a property which is excellent in alkali-developability and resistance of a weak aqueous alkali solubility. Particularly, in the case that it is applied as coatings for fine optical parts which require a shield of an ultraviolet ray in a preparation step, and in the case that it is applied for other uses requiring a fine processing, there is required that the deterioration by an ultraviolet ray can be controlled after preparation of final products together with possessing an excellent ultraviolet ray-curability in a treatment by irradiating an ultraviolet ray through a preparation step for final products.

### DISCLOSURE OF THE INVENTION

The present inventors, as a result of an intensive investigation, have found out the following matter, and the present invention was completed.

Regarding the first aspect of the present invention, a curable resin having an acid value of 20 KOH mg/g obtained by addition of an epoxy group-containing unsaturated compound (c) having an alicyclic structure has an excellent weatherability.

Regarding the second aspect of the present invention, a reaction progresses with an exceedingly excellent reactive efficiency by the use of a catalyst for addition composed of a phosphine compound having a specified structure.

Regarding the third aspect of the present invention, a resin composition has an excellent adhesion and weatherability, in which there are mixed a reactive diluent having a specified (meth)acrylic group and a polymerization initiator after obtaining a copolymer by addition of specified side chains to a main chain composed of specified compounds.

Regarding the fourth aspect of the present invention, there can be solved the above-described problems by preparing a copolymer having ultraviolet ray-absorbable groups and carboxyl groups as side chains, and then, by addition of an unsaturated compound containing an epoxy group to the carboxylic groups, resulting in that a modified copolymer shows an exceedingly excellent ultraviolet ray absorbability, and the carboxylic groups which exist in side chains optionally play a role as acidic group.

That is, the first to fourth aspects of the present invention are as follows.

According to the first aspect of the present invention, there is provided a curable resin characterized by an acid value of not more than 20 KOH mg/g, which is obtained by addition of an epoxy group-containing unsaturated compound (c) having an alicyclic structure to the carboxylic groups in a copolymer of a copolymerizable unsaturated carboxylic acid (a) with an unsaturated compound (b) other than the unsaturated carboxylic acid, and provided an outdoor coating which comprises the curable resin.

According to the second aspect of the present invention, there is provided a process for the preparation of a modified copolymer characterized in that a copolymer having carboxylic groups is obtained by copolymerization of a copolymerizable unsaturated carboxylic acid (a) with an unsaturated compound (b) other than the unsaturated carboxylic acid, and then, an epoxy group-containing unsaturated compound (c) is added to the carboxylic groups in the copolymer using a phosphine compound represented by general formula (II-1) described below as a catalyst for addition reaction, 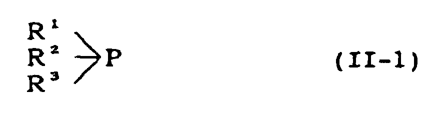 (in the formula, R¹ represents a phenyl group having an alkyl group or an alkoxy group, a linear or branched alkyl group or cycloalkoxy group, R² and R³ represent a phenyl group which may have an alkyl group or an alkoxy group, a linear or branched alkyl group or cycloalkyl group, and R¹, R², and R³ may be all different or identical, respectively).

According to the third aspect of the present invention, there is provided a curable resin composition characterized by comprising a modified copolymer (A) in which an epoxy group-containing unsaturated compound (c) having an alicyclic structure is added to carboxyl groups in a copolymer of a copolymerizable unsaturated carboxylic acid (a) with an unsaturated compound (b) other than the unsaturated carboxylic acid, at least one of a reactive diluent (B) having a (meth)acrylic group, and a polymerization initiator (C), and the curable resin composition does not substantially contain organic solvents.

According to the fourth aspect of the present invention, there is provided a modified copolymer in which an epoxy group-containing unsaturated compound (d') is added to carboxyl groups in a copolymer of a compound (a') having an unsaturated group and at least one carboxyl groups with a compound (b') having an unsaturated group and an ultraviolet ray-absorbable group.

Further, there is provided a modified copolymer in which an epoxy group-containing unsaturated compound (d') is added to carboxyl groups in a copolymer of a compound (a') having an unsaturated group and at least one carboxyl groups with a compound (b') having an unsaturated group and an ultraviolet ray-absorbable group and a (meth)acrylate (c'). Still further, there is provided the above-described modified copolymer characterized by a weight average molecular weight of 10,000-70,000. Also, there is provided the above-described modified copolymer characterized by an acid value of 0-150. And also, there is provided a radiation-curable resin composition which comprises the above-described modified copolymer (A'), a diluent (B'), and a photo-polymerization initiator (C'). Besides, there is provided a radiation-curable resin composition which comprises the above-described modified copolymer (A'), a diluent (B'), a photo-polymerization initiator (C'), and an epoxy compound (D'). In addition, there is provided the above-described radiation-curable resin composition characterized in that the diluent is an unsaturated compound (e') having at least two methacryloyl groups or acryloyl groups. Also, there is provided the above-described radiation-curable resin composition characterized in that the diluent is an unsaturated compound (f') having at least two ethylenic bonds which has a boiling point of not less than 100°C in ordinary pressures. In addition, there is provided a liquid-state resist, an optical part, and a protecting film for a polarizing plate which comprise the above-described radiation-curable resin composition.

### BEST MODE FOR CARRYING OUT THE INVENTION

Hereinafter, although the first to fourth aspects of the present invention are illustrated by respective embodiments for carrying out and Examples, the present invention is not limited by those. It is to be noted that "%" represents "% by weight" except particularly showing.

The copolymerizable unsaturated carboxylic acid (a) to be employing for the preparation of the curable resin in the present invention is a compound having an unsaturated group and at least one carboxyl groups in the molecule, and which can be copolymerized with "the unsaturated compound (b) other than the unsaturated carboxylic acid".

Specifically, there can be exemplified acrylic acid, methacrylic acid, and a compound represented by general formula (I-1). In the general formula (I-1), n is an integer of 1-10, and R¹ is a hydrogen atom or a methyl group. X represents an alkylene group, particularly, preferably an alkylene group having a carbon number of 1-3. The compound represented by the general formula (I-1) can be prepared by a reaction of an acid anhydride such as acetic anhydride with a compound which is obtained by addition of ε-caprolactone to a hydroxyethyl(meth)acrylate.

As the copolymerizable unsaturated carboxylic acid (a), in general, acrylic acid and methacrylic acid are preferably employed. It is because those can be readily obtained.

CH₂=CR¹(C=O)OCH₂CH₂O[(C=O)(CH₂)₅O]ₙ(C=O)XCOOH (I-1)

(in the formula, n is an integer of 1-10, and R¹ is a hydrogen atom or a methyl group. X is an alkylene group)

As the unsaturated compound (b) other than the unsaturated carboxylic acid, which is a compound copolymerizable with the above-described unsaturated carboxylic acid (a), there can be exemplified methyl(meth)acrylate, butyl(meth)acrylate, benzyl(meth)acrylate, cyclohexyl(meth)acrylate, isobonyl(meth)acrylate, and hydroxyethyl(meth)acrylate, and a compound represented by general formula (I-2) or esters thereof, styrenes such as styrene and hydroxystyrene, maleic anhydride, and maleic acid imide, etc.

CH₂=CR²(C=O)OCH₂CH₂O[(C=O)(CH₂)₅O)]ₙH (I-2)

(in the formula, n is an integer of 1-10, and R² is a hydrogen atom or a methyl group)

The compound represented by general formula (I-2) can be prepared by allowing to add ε-caprolactone to a hydroxyethyl (meth)acrylate.

The unsaturated compound (b) other than the unsaturated carboxylic acid can be selected depending upon uses, there can be employed methacrylates and acrylates which are usually employed.

Molar ratio of the copolymerizable unsaturated carboxylic acid (a) is usually 3:7-7:3 with respect to the unsaturated compound (b) other than the unsaturated carboxylic acid. In the range, there can be obtained a resin which is excellent in weatherability and adhesion.

The epoxy group-containing unsaturated compound (c) having an alicyclic structure for allowing to add to the carboxyl groups which are side chains is an unsaturated compound containing an epoxy group having at least one alicyclic structures in the molecule.

Specifically, there can be enumerated 3,4-epoxycyclohexyl methylacrylate, a caprolactone-modified compound thereof, 3,4-epoxycyclohexylmethylacrylate, and a caprolactone-modified compound thereof. These may be added by employing solely or in combination of two or more kinds.

The epoxy group-containing unsaturated compound (c) having an alicyclic structure is preferably employed in a double bond amount of 0.5-4.0 mol and, particularly, 1.5-3.5 mol based on 1 kg of the curable resin. In the case of less than 0.5 mol, a sufficient curability cannot be occasionally obtained and, in the case of more than 4.0 mol, storage stability becomes occasionally poor.

Further, use amount of the epoxy group-containing unsaturated compound (c) having an alicyclic structure is adjusted so that an acid value in the curable resin obtained becomes not more than 20 KOH mg/g, in particular, preferably not more than 10 KOH mg/g. In the range, weatherability is particularly excellent. Adjustment of the acid value can be carried out by controlling the ratio of the unsaturated carboxylic acid (a) with respect to the epoxy group-containing unsaturated compound (c) having an alicyclic structure to be employed.

There may be carried out a polymerization reaction of the copolymerizable unsaturated carboxylic acid (a) with the unsaturated compound (b) other than the unsaturated carboxylic acid by a conventional method and, after a copolymer was prepared, the epoxy group-containing unsaturated compound (c) having an alicyclic structure is added to the carboxylic groups which are side chains in the copolymer obtained.

Addition reaction is preferably carried out at a temperature of not more than 130°C and, in particular, more preferably 90-130°C. In the case of less than 90°C, a substantially practical reaction rate cannot be occasionally obtained and, in the case of more than 130°C, double bond portions are thermally cured by a radical polymerization, resulting in that it is anxious to produce gels.

In the addition reaction, solvents can be employed. The solvents for the reaction are not particularly limited, if those dissolve raw materials and a product. For example, there can be enumerated glycols such as ethyleneglycol, propyleneglycol, and dipropyleneglycol, glycolethers such as methylcellosolve, propyleneglycol monomethylether, and dipropyleneglycol monomethylether, glycolesters such as ethyleneglycol diacetate and propyleneglycol monomethylether acetate, and a mixed solvent thereof.

Concentration of the resin in the solvents for the reaction is preferably 20-80% by weight. In the case that the concentration of the resin is less than 20% by weight, a sufficient reaction rate cannot be occasionally obtained and, in the case of not less than 80% by weight, it is anxious that agitation becomes insufficient because of an excessively high viscosity in a reaction liquid.

In order to obtain a sufficient reaction rate, the reaction is preferably carried out using catalysts. As the catalysts, there can be employed phosphines such as triphenylphosphine and tributylphosphine, amines such as triethylamine and dimethylbenzylamine, sulfides such as dimethylsulfide and diphenylsulfide, etc., and the phosphines are preferred in view of the reaction rate.

The catalysts are employed in an amount of usually 0.01-10% by weight, and preferably 0.5-5.0% by weight based on the epoxy group-containing unsaturated compound (c) having an alicyclic structure. In the case that the amount of the catalysts is less than 0.01% by weight, a sufficient reaction rate cannot be occasionally obtained and, in the case of employing more than 10% by weight, it is anxious that a variety of physical properties are adversely affected in a resin produced.

In order to prevent generation of gels during the reaction, the reaction is preferably carried out under the presence of polymerization inhibitors such as hydroquinone, hydroquinone monomethylether, and phenothiazine. Amount of the polymerization inhibitors is preferably 1-10000 ppm based on total amount of reaction liquid. In the case that the amount of the polymerization inhibitors is not more than 1 ppm based on the total amount of reaction liquid, there cannot be occasionally obtained a sufficient effect for inhibiting the polymerization and, in the case of more than 10000 ppm, it is anxious that a variety of physical properties are adversely affected in a resin produced. Because of the same reason, the addition reaction is preferably carried out under an atmosphere of a gas containing molecular-state oxygen. Concentration of oxygen may be a concentration in which an explosive mixture is not formed in the reaction system, and it is usually adjusted to 1-7%.

Since a cured article obtained from the curable resin of the first aspect in the present invention is exceedingly excellent in weatherability, it is useful as a constructing component for coatings, inks, and adhesives. Particularly, it is useful for outdoor coatings such as materials for construction, outer walls, and cars, which are attached much importance to weatherability.

Hereinafter, the first aspect of the present invention is specifically illustrated by Examples.

### (Evaluation items)

### (I-1) Adhesion

It was evaluated according to JIS "K5400 Crosshatched test".

### (I-2) Water resistance

Surface of a coating layer was visually observed after immersed in boiled water for 1 hour.

### (I-3) Alkali resistance

Surface of a coating layer was visually observed after immersed in 5% NaOH aqueous solution at 30°C for 1 hour.

### (I-4) Acid resistance

Surface of a coating layer was visually observed after immersed in 20% hydrochloric acid at 30°C for 1 hour.

### (Example I-1)

A 3-liter separable flask equipped with an agitator, a thermometer, a reflux condenser, a dropwise funnel, and a tube for supplying nitrogen was charged with 600 g of propyleneglycol monomethylether and 10 g of t-butyl-peroxy-2-ethylhexanoate.

After temperature was elevated to 90°C, there was added dropwise a mixed solution composed of 200 g of methacrylic acid, 250 g of methylmethacrylate, 300 g of propyleneglycol monomethylether, and 10 g of azobisdimethyl varelonitrile over 3 hours, and aging was further carried out for 6 hours to obtain a solution of a resin having carboxylic groups. Reaction was carried out under a nitrogen stream.

Subsequently, there were added 425 g of 3,4-epoxycyclohexyl methylacrylate ("Cyclomer A200" manufactured by Daicel Chemical Industries, Ltd.), 45 g of triphenylphosphine, and 1.8 g of hydroquinone monomethylether, followed by allowing to react at 100°C for 20 hours to obtain a curable resin (I-A1). Reaction was carried out in a mixed gas stream containing 7% by volume of oxygen and 93% by volume of nitrogen.

As a result of titration with a phenolphthalein indicator using 0.1 N KOH ethanol solution, an acid value of the resin was 4.7 KOHmg/g.

### (Example I-2)

The same flask as in the Example I-1 was charged with 600 g of propyleneglycol monomethylether and 10 g of t-butyl-peroxy-2-ethylhexanoate. After temperature was elevated to 90°C, there was added dropwise a mixed solution composed of 200 g of methacrylic acid, 250 g of cyclohexylmethacrylate, 300 g of propyleneglycol monomethylether, and 10 g of azobisdimethyl varelonitrile over 3 hours, and aging was further carried out for 6 hours to obtain a solution of a resin having carboxylic groups. It is to be noted that reaction was carried out under a nitrogen stream.

Subsequently, there were added 425 g of 3,4-epoxycyclohexyl methylacrylate ("Cyclomer A200" manufactured by Daicel Chemical Industries, Ltd.), 45 g of triphenylphosphine, and 1.8 g of hydroquinone monomethylether, followed by allowing to react at 100°C for 20 hours to obtain a curable resin (I-A2). Reaction was carried out in a mixed gas stream containing 7% by volume of oxygen and 93% by volume of nitrogen.

As a result of titration with a phenolphthalein indicator using 0.1 N KOH ethanol solution, an acid value of the resin was 6.5 KOHmg/g.

### (Comparative Example I-1)

The same flask as in the Example I-1 was charged with 600 g of propyleneglycol monomethylether and 10 g of t-butyl-peroxy-2-ethylhexanoate. After temperature was elevated to 90°C, there was added dropwise a mixed solution composed of 200 g of methacrylic acid, 250 g of benzylmethacrylate, 300 g of propyleneglycol monomethylether, and 10 g of azobisdimethyl varelonitrile over 3 hours, and aging was further carried out for 6 hours to obtain a solution of a resin having carboxylic groups. Reaction was carried out under a nitrogen stream.

Subsequently, there were added 330 g of glycidyl methacrylate, 45 g of triphenylphosphine, and 1.8 g of hydroquinone monomethylether, followed by allowing to react at 100°C for 30 hours to obtain a curable resin (I-B1). Reaction was carried out in a mixed gas stream containing 7% by volume of oxygen and 93% by volume of nitrogen.

As a result of titration with a phenolphthalein indicator using 0.1 N KOH ethanol solution, an acid value of the resin was 5.9 KOHmg/g.

### (Comparative Example I-2)

The same flask as in the Example I-1 was charged with 600 g of propyleneglycol monomethylether and 10 g of t-butyl-peroxy-2-ethylhexanoate. After temperature was elevated to 90°C, there was added dropwise a mixed solution composed of 200 g of methacrylic acid, 250 g of benzylmethacrylate, 300 g of propyleneglycol monomethylether, and 10 g of azobisdimethyl varelonitrile over 3 hours, and aging was further carried out for 6 hours to obtain a solution of a resin having carboxylic groups. Reaction was carried out under a nitrogen stream.

Subsequently, there were added 350 g of 3,4-epoxycyclohexyl methylacrylate ("Cyclomer A200" manufactured by Daicel Chemical Industries, Ltd.), 45 g of triphenylphosphine, and 1.8 g of hydroquinone monomethylether, followed by allowing to react at 100°C for 30 hours to obtain a curable resin (I-B2). Reaction was carried out in a mixed gas stream containing 7% by volume of oxygen and 93% by volume of nitrogen.

As a result of titration with a phenolphthalein indicator using 0.1 N KOH ethanol solution, an acid value of the resin was 30.1 KOHmg/g.

### (Examples I-3 and I-4, Comparative Examples I-3 and I-4)

As Example I-3, there were mixed 90 parts by weight of the curable resin (I-A1) prepared in the Example I-1 and 2 parts by weight of "Irugacure 907" manufactured by Ciba-Geigy which is an initiator to obtain a curable resin composition.

The curable resin composition was coated on a Bondelite steel plate PB-144 (manufactured by Nihon Test Panel, Ltd.) in the layer thickness of 10 micron. After exposed to light with a high-pressure mercury lamp (exposing dose of 1000 mJ/cm²), it was thermally-treated at 150°C for 20 minutes. There were evaluated adhesion, water resistance, alkali resistance, and acid resistance in coating layer obtained. Results are shown in Table I-1.

The same operations were followed as in the Example I-3, except that there was employed the curable resin (I-A2) prepared in the Example I-2 in place of the curable resin prepared in the Example I-1, and an evaluation was carried out in relation to a coating layer. This is designated as Example I-4.

The same operations were followed as in the Example I-3, except that there was employed the curable resin (I-B1) prepared in the Comparative Example I-1 in place of the curable resin prepared in the Example I-1, and an evaluation was carried out in relation to a coating layer. This is designated as Comparative Example I-3.

The same operations were followed as in the Example I-3, except that there was employed the curable resin (I-B2) prepared in the Comparative Example I-2 in place of the curable resin prepared in the Example I-1, and an evaluation was carried out in relation to a coating layer. This is designated as Comparative Example I-4.

**Table I-1**

| | Resin employed | Adhesion | Water resistance | Alkali resistance | Acid resistance |
|---|---|---|---|---|---|
| Example I-3 | I-A1 | no peeled | normal | normal | normal |
| Example I-4 | I-A2 | no peeled | normal | normal | normal |
| Comparative Example I-3 | I-B1 | no peeled | surface whitening | surface whiteing | surface whitening |
| Comparative Example 1-4 | I-B2 | no peeled | normal | surface whitening | normal |

Hereinafter, there is detailedly illustrated the second aspect of the present invention.

The copolymerizable unsaturated carboxylic acid (a) is the same compound as described in the first aspect of the present invention, which is employed for preparing the modified copolymer.

The unsaturated compound (b) other than the unsaturated carboxylic acid is the same compound as described in the first aspect of the present invention. Because the (b) can be readily obtained.

Constructing molar ratio of the copolymerizable unsaturated carboxylic acid (a) with respect to the unsaturated compound (b) other than the unsaturated carboxylic acid is the same as described in the first aspect of the present invention. Because, in the range, there can be obtained a resin which is excellent in weatherability and adhesion.

The epoxy group-containing unsaturated compound (c) to be added to carboxylic groups which are a side chain is the same compound as described in the first aspect of the present invention and, further, there can be enumerated glycidyl methacrylate and methylglycidylmethacrylate, and the like.

The epoxy group-containing unsaturated compound (c) is preferably employed in a double bond amount of 1.0-3.5 mol and, particularly, 1.5-3.0 mol based on 1 kg of the modified copolymer obtained. In the case of less than 1.0 mol, a sufficient curability cannot be occasionally obtained and, in the case of more than 3.5 mol, storage stability becomes occasionally poor.

Polymerization reaction of the copolymerizable unsaturated carboxylic acid (a) with the unsaturated compound (b) other than the unsaturated carboxylic acid is likewise carried out as in the reaction described in the first aspect of the invention.

In the addition reaction, a phosphine compound represented by general formula (II-1) described below is employed as a catalyst in order to obtain a sufficient reaction rate, 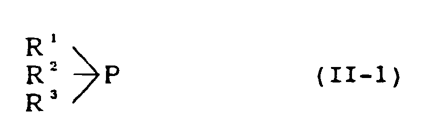 (in the formula, R¹ represents a phenyl group having an alkyl group or an alkoxy group and a linear or branched alkyl group or cycloalkoxy group, R² and R³ represent a phenyl group which may have an alkyl group or an alkoxy group and a linear or branched alkyl group or cycloalkyl group, and R¹, R², and R³ may be all different or identical, respectively).

In the formula, as the phenyl group having an alkyl group or an alkoxy group, there can be exemplified 2-methylphenyl group, 3-methylphenyl group, 4-methylphenyl group, 2,4,6-trimethylphenyl group, 2-methoxyphenyl group, 3-methoxyphenyl group, 4-methoxyphenyl group, 2-ethoxyphenyl group, 3-ethoxyphenyl group, 4-ethoxyphenyl group, 2,3,4-trimethoxyphenyl group, and 2,4,6-trimethoxyphenyl group, and the like. Of those, there are preferred methylphenyl groups, methoxyphenyl groups, and trimethoxyphenyl groups.

As the linear or branched alkyl group, there can be exemplified methyl group, butyl group, ethyl group, propyl group, isopropyl group, isobutyl group, and the like. Of those, there are preferred methyl groups and butyl groups.

As the cycloalkyl group, there can be exemplified cyclohexcyl group, cyclopentyl group, and cyclooctyl group. Of those, cyclohexcyl group is preferred.

It is to be noted that the compound represented by the general formula (II-1) may be employed solely or in combination of two or more kinds.

Specifically, there can be enumerated tris(4-methylphenyl)phosphine, tris(4-methoxyphenyl)phosphine, tris(2,4,6-trimethylphenyl)phosphine, tris(2,4,6-trimethoxyphenyl)phosphine, methyldiphenylphosphine, dimethylphenylphosphine, tributylphosphine, and tricyclohexyl phosphine, and the like.

The phosphine compounds are employed in an amount of usually 0.1-2% by weight, and preferably 0.2-0.8% by weight based on total reaction liquids. In the case that the use amount of the phosphine compounds is less than 0.1% by weight based on total reaction liquids, a sufficient reaction rate cannot be occasionally obtained and, in the case of adding more than 2% by weight, it is anxious that a variety of physical properties are adversely affected in a resin produced.

Temperature conditions in the addition reaction are the same temperature conditions as described in the first aspect of the invention.

Solvents in the addition reaction are the same solvents as in the addition reaction described in the first aspect of the invention.

Resin concentration in the solvents for the reaction is preferably 20-60% by weight. In the case that the resin concentration is less than 20% by weight, a sufficient reaction rate cannot be occasionally obtained and, in the case of more than 60% by weight, it is anxious that agitation becomes insufficient because of an excessively high viscosity in a reaction liquid.

A method for preventing the generation of gel during the reaction is the same method for preventing as described in the first aspect of the present invention.

In the addition reaction, the phosphine compound represented by the general formula (II-1) and a polymerization inhibitor which is optionally added are preferably added as a uniform solution which is in advance prepared using an appropriate solvent. It is because reaction time of period is shortened.

Particularly, in the case that there are employed a polymerization inhibitor which is a solid at ordinary temperatures and a phosphine compound which is a catalyst, if these are mixed as it is, there is required a long time of period for uniformly dissolving into a reaction liquid.

If the solvent to be employed has a higher boiling point than reaction temperature and it can dissolve the polymerization inhibitor and the phosphine compound and, moreover, it is uniformly mixed with the reaction liquid, those are not particularly limited. There are preferably employed the same solvent components contained in the reaction liquid.

The modified copolymer obtained by the second aspect of the invention is useful as a photo-curable resin, particularly, as one component for a photoresist composition.

Hereinafter, the second aspect of the present invention is specifically illustrated by Examples.

### (Preparation Example II-1)

A 2-liter separable flask equipped with an agitator, a thermometer, a reflux condenser, a dropwise funnel, and a tube for supplying nitrogen was charged with 175 g of dipropyleneglycol monomethylether and 8.2 g of t-butyl-peroxy-2-ethylhexanoate. After temperature was elevated to 90°C, there was added dropwise a mixed solution composed of 118 g of methacrylic acid, 86 g of methylmethacrylate, 163 g of dipropyleneglycol monomethylether, and 6.5 g of azobisdimethyl varelonitrile over 3 hours, and aging was further carried out for 6 hours to obtain a solution of an acrylic resin having carboxylic groups. Reaction was carried out under a nitrogen stream.

### (Example II-1)

In the solution of a resin obtained in the Preparation Example II-1, there were added 139 g of 3,4-epoxycyclohexyl methylacrylate ("Cyclomer A200" manufactured by Daicel Chemical Industries, Ltd.), 1.71 g (0.006 mol) of tricyclohexyl phosphine, and 0.7 g of hydroquinone monomethylether, followed by allowing to react at 100°C under a mixed gas stream containing 7% by volume of oxygen and 93% by volume of nitrogen. As a result of an analysis with a gaschromatograph, 97% of 3,4-epoxycyclohexyl methylacrylate reacted at 7 hours later.

### (Example II-2)

In the solution of a resin obtained in the Preparation Example II-1, there were added 139 g of 3,4-epoxycyclohexyl methylacrylate ("Cyclomer A200" manufactured by Daicel Chemical Industries, Ltd.), 1.86 g (0.006 mol) of tris(4-methylphenyl) phosphine, and 0.7 g of hydroquinone monomethylether, followed by allowing to react at 100°C under a mixed gas stream containing 7% by volume of oxygen and 93% by volume of nitrogen. As a result of an analysis with a gaschromatograph, 96% of 3,4-epoxycyclohexyl methylacrylate reacted at 6 hours later.

### (Example II-3)

In the solution of a resin obtained in the Preparation Example II-1, there were added 139 g of 3,4-epoxycyclohexyl methylacrylate ("Cyclomer A200" manufactured by Daicel Chemical Industries, Ltd.), 3.25 g (0.006 mol) of tris(2,4,6-trimethoxyphenyl)phosphine, and 0.7 g of hydroquinone monomethylether, followed by allowing to react at 100°C under a mixed gas stream containing 7% by volume of oxygen and 93% by volume of nitrogen. As a result of an analysis with a gaschromatograph, 96% of 3,4-epoxycyclohexyl methylacrylate reacted at 5 hours later.

### (Comparative Example II-1)

In the solution of a resin obtained in the Preparation Example II-1, there were added 139 g of 3,4-epoxycyclohexyl methylacrylate ("Cyclomer A200" manufactured by Daicel Chemical Industries, Ltd.), 1.57 g (0.006 mol) of triphenylphosphine, and 0.7 g of hydroquinone monomethylether, followed by allowing to react at 100°C under a mixed gas stream containing 7% by volume of oxygen and 93% by volume of nitrogen. As a result of an analysis with a gaschromatograph, only 80% of 3,4-epoxycyclohexyl methylacrylate reacted at 7 hours later.

### (Comparative Example II-2)

In the solution of a resin obtained in the Preparation Example II-1, there were added 139 g of 3,4-epoxycyclohexyl methylacrylate ("Cyclomer A200" manufactured by Daicel Chemical Industries, Ltd.), 0.81 g (0.006 mol) of dimethylbenzylamine, and 0.7 g of hydroquinone monomethylether, followed by allowing to react at 100°C under a mixed gas stream containing 7% by volume of oxygen and 93% by volume of nitrogen. As a result of an analysis with a gas chromatograph, only 70% of 3,4-epoxycyclohexyl methylacrylate reacted at 7 hours later.

Hereinafter, the third aspect of the present invention is illustrated in detail.

In the modified copolymer (A), a number average molecular weight is preferably 1,000-100,000, in particular, more preferably 2,000-30,000. Further, an acid value is 50-700 KOH mg/g, in particular, preferably 100-500 KOH mg/g.

It is to be noted that "not substantially contain organic solvents" in the present invention means "ingredients having a boiling point of not more than 250°C at ordinary pressures occupy not more than 5% by weight, and preferably 1% by weight in uncured ingredients of the composition".

The modified copolymer (A) to be employed for the curable resin composition of the present invention is a modified copolymer in which an epoxy group-containing unsaturated compound (c) having an alicyclic structure is added to carboxyl groups in a copolymer of a copolymerizable unsaturated carboxylic acid (a) with an unsaturated compound (b) other than the unsaturated carboxylic acid.

The modified copolymer (A) can be prepared by the following methods.

The copolymerizable unsaturated carboxylic acid (a) to be employed is the same as described in the first aspect of the present invention.

The unsaturated compound (b) other than the unsaturated carboxylic acid to be employed is the same as described in the first aspect of the present invention.

Constructing molar ratio of the copolymerizable unsaturated carboxylic acid (a) with respect to the unsaturated compound (b) other than the unsaturated carboxylic acid is the same as described in the first aspect of the present invention.

The epoxy group-containing unsaturated compound (c) having an alicyclic structure to be added to carboxyl groups which are a side chain in the copolymer obtained hereinabove is the same described as in the first invention. By allowing to add the compound having an alicyclic structure, water resistance and acid resistance are improved in the composition.

The epoxy group-containing unsaturated compound (c) is employed in an amount of 0.5-4.0 mol, in particular, preferably 1.0-3.5 mol of double bond amount based on 1 kg of the modified copolymer (A). In the case of less than 0.5 mol, sufficient curability is not occasionally obtained and, in the case of more than 4.0 mol, storage stability is occasionally poor.

Polymerization reaction of the copolymerizable unsaturated carboxylic acid (a) with respect to the unsaturated compound (b) other than the unsaturated carboxylic acid is likewise carried out such as the reaction described in the first aspect of the present invention.

Solvents in the addition reaction are the same as in the solvents in the addition reaction described in the first aspect of the present invention. Further, there can be employed the reactive diluent (B) having at least one (meth)acrylic group which is described hereinafter as a solvent for the reaction.

It is to be noted that in the case that organic solvents other than the reactive diluent (B) are employed as a solvent for the reaction, those may be removed by publicly-known common means such as distillation and extraction after the completion of the reaction or after the preparation of the curable resin composition.

Resin concentration in the solvent for the reaction is the same as the resin concentration described in the Example 1.

In order to obtain a sufficient reaction rate, the reaction is preferably carried out using catalysts. The catalysts and the amount thereof are the same as the catalysts and the amount thereof described in the Example 1.

Methods for preventing the production of gels in the reaction are the same as the methods for preventing described in the Example 1.

If it is a compound capable of dissolving the modified copolymer (A), there is not particularly limited the reactive diluent (B) having at least one of (meth)acrylic group to be employed for the curable resin composition which is the third aspect of the present invention. For example, there are exemplified an alkyl or cycloalkyl(meth)acrylate such as isobonyl(meth)acrylates, cyclohexyl(meth)acrylates, and octyl(meth)acrylates, a hydroxyalkyl(meth)acrylate such as 2-hydroxyethyl(meth)acrylates and 3-hydroxypropyl(meth)acrylates, a mono or di(meth)acrylate of a glycol such as a mono or di(meth)acrylate of ethyleneglycol, a (meth)acrylate of methoxyethyleneglycol, a mono or di(meth)acrylate of tetraethyleneglycol, a mono or di(meth)acrylate of a glycol such as a mono or di(meth)acrylate of tripropyleneglycol, a (meth)acrylate having an epoxy group such as 3,4-epoxycyclohexylmethyl(meth)acrylate and glycidyl(meth)acrylate, a (meth)acrylate of a polyol or an adduct of ethyleneoxide such as glycerinedi(meth)acrylate, trimethylolpropane tri(meth)acrylate, a tri or tetra(meth)acrylate of pentaerythritol, and a polyol such as dipentaerythritol hexaacrylate or a mono or di(meth)acrylate of an alkyleneoxide thereof, and the like. Of those, there is preferred one having an ignition point of not less than 100°C in view of ensuring safeness in the preparation process.

The component (B) is mixed in a proportion of 1-150 parts by weight based on 100 parts by weight of the component (A).

As the polymerization initiator (C) to be employed in the curable resin composition of the third aspect of the present invention, there can be unlimitedly employed benzoins, acetophenones, ketals, benzophenones, xanthones, and peroxides, etc., which are publicly-known and commonly used. The polymerization initiator is preferably employed in a proportion of 1-10% by weight based on the curable resin composition.

In the curable resin composition of the present invention, there can be optionally mixed a reactive resin such as an epoxy resin, a filler such as barium sulphate, silicone oxide, talc, clay, and calcium carbonate, a coloring pigment such as Phthalocyanine green, Crystalviolet, titanium oxide, and carbon black, a variety of additives such as an adhesion agent and a leveling agent, a polymerization inhibitor such as hydroquinone, hydroquinone monomethylether, and phenothiazine, and the like.

The curable resin composition of the third aspect in the present invention is useful as constructing ingredients for coatings, inks, and adhesives, and the like.

Hereinafter, the third aspect of the present invention is specifically illustrated by Examples.

### (Evaluation items)

(III-1) adhesion, (III-2) water resistance, and (III-3) acid resistance were likewise measured such as the (I-1) adhesion, (I-2) water resistance, and (I-3) acid resistance described in the first aspect of the present invention.

### (Preparation Example III-1)

A 5-liter separable flask equipped with an agitator, a thermometer, a reflux condenser, a dropwise funnel, and a tube for supplying nitrogen was charged with 600 g of propyleneglycol monomethylether and 10 g of t-butyl-peroxy-2-ethylhexanoate.

After temperature was elevated to 90°C, there was added dropwise a mixed solvent composed of 200 g of methacrylic acid, 250 g of benzylmethacrylate, 300 g of propyleneglycol monomethylether, and 10 g of azobisdimethyl varelonitrile over 3 hours and, further, aging was conducted for 6 hours to obtain a solution of a resin having carboxylic groups. Reaction was carried out in a nitrogen stream.

Subsequently, there were added 425 g of 3,4-epoxycyclohexyl methylacrylate ("Cyclomer A200" manufactured by Daicel Chemical Industries, Ltd.), 45 g of triphenylphosphine, and 1.8 g of hydroquinone monomethylether, followed by allowing to react at 100°C for 20 hours to obtain a curable resin solution. Reaction was carried out in a mixed gas stream containing 7% by volume of oxygen and 93% by volume of nitrogen.

Further, 900 g of tetraethyleneglycol diacrylate was added and, propyleneglycol monomethylether was distilled out at 50°C and 30 Torr. Modified curable resin (III-A1) remained in the flask was analyzed by a gaschromatograph and, as a result, the concentration of propyleneglycol monomethylether was 0.7% by weight.

### (Preparation Example III-2)

The same flask as in the Preparation Example III-1 was charged with 350 g of heptane and 10 g of t-butyl-peroxy-2-ethylhexanoate. After temperature was elevated to 90°C, there was added dropwise a mixed solution composed of 200 g of methacrylic acid, 250 g of benzylmethacrylate, 300 g of heptane, and 10 g of azobisdimethyl varelonitrile over 3 hours and, further, aging was carried out for 6 hours. After the completion of reaction, white-colored powder precipitated was filtered and dried to obtain powder of a resin having carboxylic groups. The reaction was carried out under a nitrogen stream.

Subsequently, there were added 300 g of the above-described resin powder, 285 g of 3,4-epoxycyclohexyl methylacrylate ("Cyclomer A200" manufactured by Daicel Chemical Industries, Ltd.), 600 g of tetraethyleneglycol diacrylate, 30 g of triphenylphosphine, and 1.2 g of hydroquinone monomethylether into the same flask as in the Preparation Example III-1, followed by allowing to react at 100°C for 20 hours to obtain a modified curable resin (III-A2). Reaction was carried out in a mixed gas stream containing 15% by volume of oxygen and 85% by volume of nitrogen.

### (Comparative Preparation Example III-1)

The same flask as in the Preparation Example III-1 was charged with 600 g of propyleneglycol monomethylether and 10 g of t-butylperoxy-2-ethylhexanoate. After temperature was elevated to 90°C, there was added dropwise a mixed solution composed of 200 g of methacrylic acid, 250 g of benzylmethacrylate, 300 g of propyleneglycol monomethylether, and 10 g of azobisdimethyl varelonitrile over 3 hours and, further, aging was carried out for 6 hours to prepare a solution of a resin having carboxylic groups. The reaction was carried out under a nitrogen stream.

Subsequently, there were added 330 g of glycidyl methacrylate, 45 g of triphenylphosphine, and 1.8 g of hydroquinone monomethylether, followed by allowing to react at 100°C for 30 hours to obtain a modified curable resin solution. Reaction was carried out in a mixed gas stream containing 7% by volume of oxygen and 93% by volume of nitrogen.

Further, 900 g of tetraethyleneglycol diacrylate was added and, propyleneglycol monomethylether was distilled out at 50°C and 30 Torr. Modified curable resin (III-B1) remained in the flask was analyzed by a gaschromatograph and, as a result, the concentration of propyleneglycol monomethylether was 0.8% by weight.

### (Examples III-1, III-2, and Comparative Example III-1)

As Example III-1, there were mixed 50 parts by weight of the modified curable resin (III-A1) prepared in the Preparation Example III-1, 50 parts by weight of trimethylolpropane triacrylate, and 2 parts by weight of "Irugacure 907" which is an initiator manufactured by Ciba-Geigy to prepare a curable resin composition.

The curable resin composition was coated on a Bondelite steel plate PB-144 (manufactured by Nihon Test Panel, Ltd.) in the layer thickness of 10 microns. After exposed to light with a high-pressure mercury lamp (exposing dose of 1000 mJ/cm²), it was thermally-treated at 150°C for 20 minutes. There were evaluated adhesion, water resistance, and acid resistance in relation to a coating layer obtained. Results are shown in Table III-1.

The same operations were followed as in the Example III-1, except that there was employed the curable resin (III-A2) prepared in the Preparation Example III-2 in place of the modified curable resin prepared in the Preparation Example III-1, and an evaluation was carried out in relation to a coating layer. This is designated as Example III-2.

The same operations were followed as in the Example III-1, except that there was employed the modified curable resin (III-B1) prepared in the Comparative Preparation Example III-1 in place of the modified curable resin prepared in the Preparation Example III-1, and an evaluation was carried out in relation to a coating layer. This is designated as Comparative Example III-1.

Results are shown in Table III-1.

**Table III-1**

| | Resin employed | Adhesion | Water resistance | Acid resistance |
|---|---|---|---|---|
| Example III-1 | III-A1 | no peeled | normal | normal |
| Example III-2 | III-A2 | no peeled | normal | normal |
| Comparative Example III-1 | III-B1 | no peeled | Surface whitening | Surface whitening |

Hereinafter, the fourth aspect of the present invention is illustrated in detail.

### (Modified copolymer)

The fourth aspect of the present invention relates to a modified copolymer in which an epoxy group-containing unsaturated compound (d') is added to carboxyl groups in a copolymer of a compound (a') having an unsaturated group and at least one carboxyl groups with a compound (b') having an unsaturated group and an ultraviolet ray-absorbable group, or carboxyl groups in a copolymer of the compound (a'), the compound (b'), and a (meth)acrylate (c').

The modified copolymer in the fourth aspect of the present invention has a weight average molecular weight of preferably 10,000-70,000, and more preferably 15,000-70,000. Because there can be obtained a product having a high sensitivity.

The modified copolymer in the fourth aspect of the present invention has an acid value of preferably 0-150 mgKOH/g. A most appropriate range is different depending upon uses.

In the case that it is employed in a field of coatings in which it is cured by a radioactive ray or heating to obtain a coating layer, the acid value is preferably less than 50 KOHmg/g.

Because there can be obtained a product having a high weatherability.

Further, in the case that a surface precise processing is required such as a resist for a precise processing, a photoresist, a liquid state resist, an ink for a color filter, and a prism sheet, or in the case that images are formed by developing with alkalis, etc. after cured by a radioactive ray, the acid value is preferably 50-150 KOHmg/g. In the case that the acid value exceeds 150 KOHmg/g, moisture resistance becomes poor in a cured layer.

### (Process for the preparation of Modified copolymer)

The modified copolymer in the fourth aspect of the present invention is prepared by allowing to copolymerize a compound (a') having an unsaturated group and at least one carboxyl groups with a compound (b') having an unsaturated group and an ultraviolet ray-absorbable group to obtain a copolymer, and then by allowing to add an epoxy group-containing unsaturated compound (c') to carboxyl groups in the copolymer obtained.

As the compound (a') having an unsaturated group and at least one carboxyl groups, there can be exemplified acrylic acid, methacrylic acid, a modified unsaturated carboxylic acid in which a chain is extended between the unsaturated group and the carboxyl groups, for example, β-carboxyethyl(meth)acrylate, 2-acryloyloxyethyl succinate, 2-acryloyloxyethyl phthalate, 2-acryloyloxyethyl hexahydrophthalate, a lactone-modified unsaturated monocarboxylic acid having an ester bond, and a modified unsaturated monocarboxylic acid having ether bonds. Or, there may be a compound having at least two carboxyl groups in the molecule such as maleic acid. Those may be employed solely or in combination of two or more kinds.

As the compound (b') having an unsaturated group and an ultraviolet ray-absorbable group, there can be exemplified a triazol-based (meth)acrylate such as 2-(2'-hydroxy-5'-methacryloyloxyethylphenyl)-2H-benzotriazol, 2-(2'-hydroxy-5'-methacryloyloxyethylphenyl)-5-chloro-2H-benzotriazol, 2-(2'-hydroxy-5'-methacryloyloxypropylphenyl)-2H-benzotriazol, 2-(2'-hydroxy-5'-methacryloyloxypropylphenyl)-5-chloro-2H-benzotriazol, 2-(2'-hydroxy-5'-methacryloyloxypropyl-3'-t-butylphenyl)-2H-benzotriazol, and 2-(2'-hydroxy-5'-methacryloyloxypropyl-3'-t-butylphenyl)-5-chloro-2H-benzotriazol, an ethylenic unsaturated derivative such as 2-hydroxy-4-methacryloxy-benzophenone, allyl-2-hydroxy-benzophenone, and 2,4-dihydroxy-benzophenone.

The compound (b') is preferably allowed to copolymerize in 0.05-30% by weight based on the total weight of the modified copolymer. In the case that the modified copolymer is employed for processing such as films, it is appropriately selected by calculating the content of the ultraviolet ray-absorbable group contained in a unit volume.

The modified copolymer of the present invention may be a copolymer containing a (meth)acrylate (c') in a main chain of the modified copolymer. As the (meth)acrylate (c'), in addition to the unsaturated compound (b) other than the unsaturated carboxylic acid of the first aspect of the present invention, there can be exemplified alkyl(meth)acrylates such as ethyl(meth)acrylate, propyl(meth)acrylate, pentyl(meth)acrylate, and hexyl(meth)acrylate, (meth)acrylates having hydroxyl group such as hydroxypropyl(meth)acrylate and hydroxybutyl (meth)acrylate, (meth)acrylates such as methoxydiethyleneglycol (meth)acrylate, ethoxydiethyleneglycol(meth)acrylate, isooctyloxy diethyleneglycol(meth)acrylate, phenoxytriethyleneglycol (meth)acrylate, methoxytriethyleneglycol(meth)acrylate, and methoxypolyethyleneglycol(meth)acrylate.

The (meth)acrylate (c') is allowed to copolymerize in an amount of 0-90% by weight based on the total weight of the modified copolymer. In the case of exceeding 90% by weight, sensitivity remarkably lowers.

Methods for allowing to copolymerize respective copolymerization components are not particularly limited, and those may be carried out according to publicly-known methods. For example, reaction is carried out in solvents which do not participate in the reaction and using a radical initiator at 0-150°C for 1-15 hours.

As the epoxy group-containing unsaturated compound (d') to be allowed to react by addition to carboxyl groups in the copolymer obtained as described hereinabove, there can be employed a compound shown by general formula (IV-1) described below. 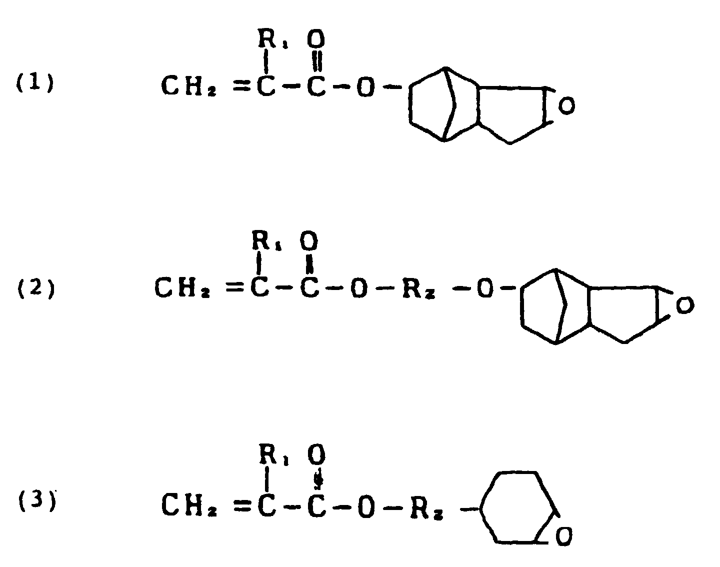 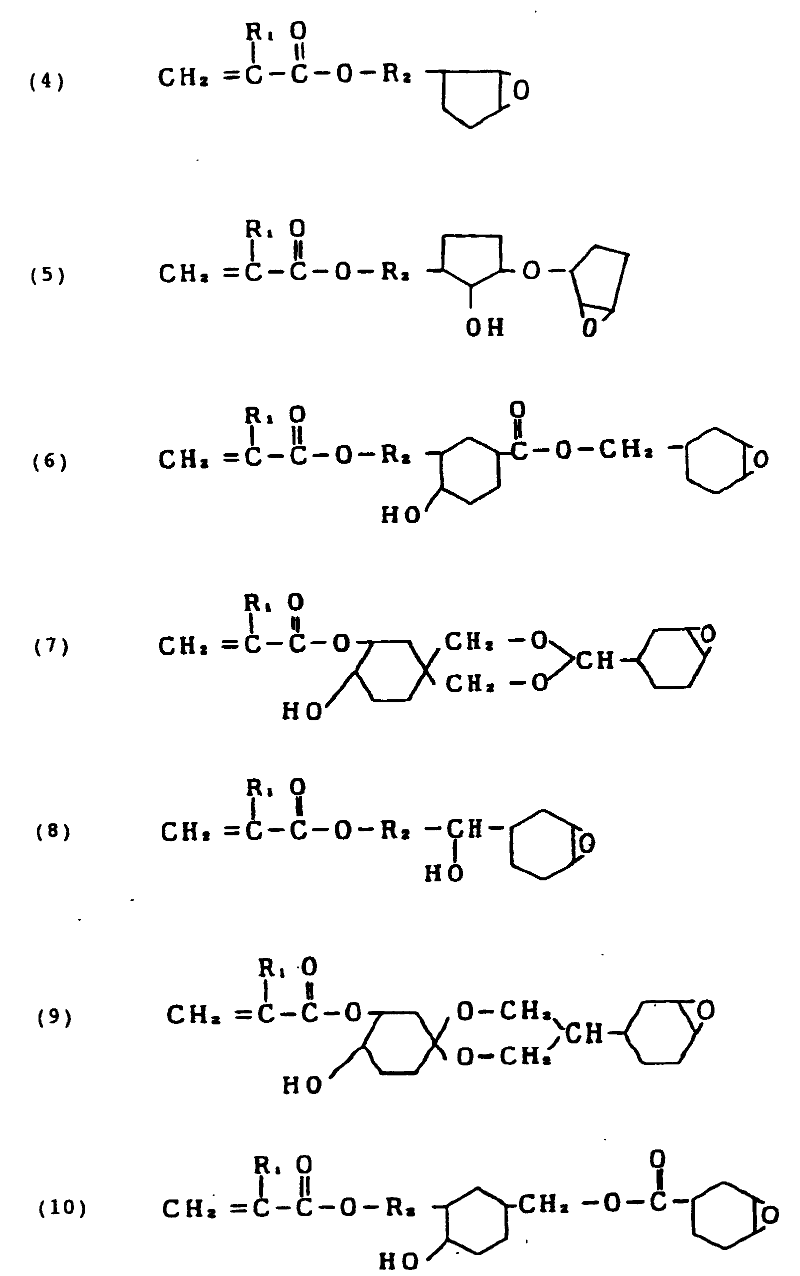 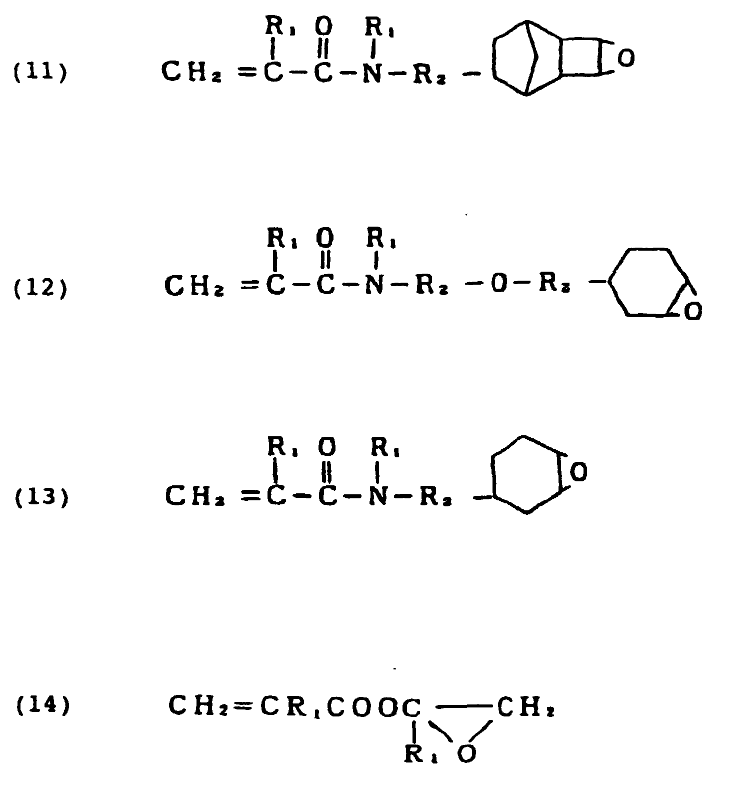 (in the respective formulae, respective R¹ represent a hydrogen atom or a methyl group, and respective R² represent a divalent hydrocarbon group having a carbon number of 1-6)

Of those, there are most preferred 3,4-cyclohexylmethyl (meth)acrylate, glycidyl(meth)acrylate, and β-methylglycidyl (meth)acrylate.

The amount of the epoxy group-containing unsaturated compound to be added ranges in 5-50% by mol based on 1 mol of the modified copolymer. In the case that the amount to be added is less than 5% by mol, curability by radiation becomes worse, and physical properties lower in a cured layer. On the other hand, in the case of not less than 50% by mol, storage stability becomes worse in resins.

In ring-opening addition reaction of an epoxide, catalysts can be employed.

As the catalysts, there can be exemplified a tertiary amine such as dimethylbenzyl amine, triethyl amine, tetramethylethylene diamine, and tri-n-octyl amine, quaternary ammonium salts such as tetramethylammonium chloride, tetramethylammonium bromide, and tetrabutylammonium bromide, alkyl ureas such as tetramethyl urea, alkyl guanidines such as tetramethyl guanidine, phosphine-based compounds such as triphenylphosphine, and salts thereof. These may be employed solely or in combination of two or more kinds.

The catalysts are preferably employed in 0.01-10% by weight, preferably 0.5-3.0% by weight based on the epoxy compound. In the case of less than 0.01% by weight, a catalytic effect is low and, even in the case of adding an amount exceeding 10% by weight, an effect is not improved.

In the reaction, solvents can be employed. As the solvents to be employed, which are not particularly limited, and there can be exemplified aromatic hydrocarbons such as benzene, toluene, and xylene, alcohols such as methanol, ethanol, and 2-propanol, ketones such as acetone, methylethyl ketone, and methylisobutyl ketone, ethers such as diethylether, dibutylether, and dioxane, esters such as ethyl acetate, isobutyl acetate, ethyleneglycol monoacetate, propyleneglycol monoacetate, and dipropyleneglycol monoacetate, ethyleneglycol monoalkyl ethers, diethyleneglycol monoalkyl ethers, propyleneglycol monoalkylethers, dipropyleneglycol monoalkylethers, butyleneglycol monoalkylethers, ethyleneglycol dialkyl ethers, diethyleneglycol dialkyl ethers such as diethyleneglycol dimethyl ether and diethyleneglycol diethyl ether, ethyleneglycol monoalkyl ether acetates, diethyleneglycol monoalkyl ether acetates, amides such as dimethylformamide and dimethylacetoamide, and halogenated hydrocarbons such as carbon tetrachloride and chloroform. These may be employed solely or in combination of two or more kinds.

Reaction temperature is preferably not more than 130°C and, particularly, preferably 90-120°C. In the temperature range, sufficient reaction rate is ensured and, further, there is suppressed the generation of crosslinked and gelled products.

### (Radiation-curable resin composition)

As the diluent (B') to be employed for the radiation-curable resin composition of the present invention, there are preferred the unsaturated compound (e') having at least two acryloyl groups or methacryloyl groups, and there can be exemplified ethyleneglycol diacrylate, ethyleneglycol dimethacrylate, diethyleneglycol diacrylate, diethyleneglycol dimethacrylate, glycerine triacrylate, glycerine trimethacrylate, propylenediacrylate, propylenedimethacrylate, 1,2,4-butanetriol triacrylate, 1,2,4-butanetriol trimethacrylate, 1,4-benzenediol diacrylate, 1,4-benzenedi(meth)acrylate, a bisacrylate or a bismethacrylate of a polyethyleneglycol having a molecular weight of 200-500, trimethylolpropane triacrylate, trimethylolpropane trimethacrylate, pentaerythritol tetraacrylate, pentaerythritol tetramethacrylate, dipentaerythritol hexaacrylate, and the like, an oligomer such as a melamine acrylate, an epoxy acrylate, a urethane acrylate, and a polyester acrylate, methylene bisacrylamide, methylene bismethacrylamide, diethylenetriamine triacrylamide bis(methacrylamidepropoxy)ethane, diethylenetriaminetrimethacrylamide bis(methacrylamide propoxy)ethane, bismethacrylamide ethylmethacrylate-N-[(β-hydroxyethyloxy)ethyl]acrylamide, triacrylisocyanate, and trimethacrylisocyanate, and the like. By mixing those, viscosity can be appropriately adjusted.

As the diluent (B'), of the unsaturated compound (e'), there can be particularly employed an unsaturated compound (f') having at least two ethylenic bonds which has a boiling point of not less than 100°C at ordinary pressures.

As other diluent (B'), there can be exemplified compounds not having an ethylenic unsaturated bond, specifically, organic solvents such as ethyleneglycol monoalkylethers, diethyleneglycol monoalkylethers, ethyleneglycol alkylethers, diethyleneglycol dialkylethers, ethyleneglycol monoalkylether acetates, diethyleneglycol monoalkyl acetates, cyclohexane, tetrahydronaphthaline, and a petroleum naphtha. By mixing the diluents, even in the case that the modified copolymer is employed for coatings, etc., it can be employed in a state by which coating is readily carried out.

In the radiation-curable resin composition of the present invention, the photo-polymerization initiator (C') is mixed.

As the photo-polymerization initiator (C'), although it is not particularly limited, there can be exemplified 2-methyl-1-[4-(methylthio)phenyl]-2-morpholino-propane-1 ("Irugacure 907" manufactured by Ciba-Geigy, AG). In addition, other photo-polymerization initiators can be also employed in combination.

As the other photo-polymerization initiator to be employed in combination, there can be exemplified p-phenylbenzophenone, benzyldimethylketal, 2,4-dimethylthioxantone, 2,4-diethylthioxantone, benzoinethylether, benzoinisopropylether, benzoinisobutylether, 4,4'-diethylaminobenzophenone, and an ethylester of p-dimethylaminobenzoic acid, and the like.

As the epoxy compound (D') to be mixed in the radiation-curable resin composition which comprises the (A'), the (B'), and the (C'), there is an epoxidised resin having unsaturated groups such as an epoxidized polybutadiene and an epoxidized butadiene-styrene block copolymer and, as commercially-supplied products, there are "Epolead PB" and "ESBS" which are manufactured by Daicel Chemical Industries, Ltd. As alicyclic epoxy resins, there are "Celloxide 2021" which is 3,4-epoxycyclohexylmethyl-3',4'-cyclohexanecarboxylate and "EHPE" which are manufactured by Daicel Chemical Industries, Ltd., "Epomic VG-3101" manufactured by Mitsui Kagaku, Ltd., "E-1031S" manufactured by Yuka Shell Epoxy, Ltd., "TETRAD-X" and "TETRAD-C" which are manufactured by Mitsubishi Gas Kagaku, Ltd., and "EPB-13" and "EPB-27" which are manufactured by Nihon Soda, Ltd., and the like.

As a copolymerization type epoxy resin, there are copolymers such as a copolymer of glycidylmethacrylate with styrene, "CP-50M" and "CP-50S" which are manufactured by Nihon Yushi, Ltd., and which are a copolymer of glycidylmethacrylate with styrene and methylmethacrylate, and a copolymer of glycidylmethacrylate with cyclohexylmaleimide, and the like.

As a novolak type epoxy resin, there are products obtained by a reaction of novolaks with epichlorohydrin and/or methylepichlorohydrin. The novolaks are obtained by a reaction of phenols such as phenol, cresol, a halogenated phenol, and an alkyl phenol with formaldehyde under the presence of acidic catalysts. As commercially supplied products thereof, there are "EOCN-103", "EOCN-104S", "EOCN-1020", "EOCN-1027", "EPPN-201", and "BREN-S" which are manufactured by Nihon Kayaku, Ltd., "DEN-431" and "DEN-439" which are manufactured by Dow Chemicals, Ltd., "N-73" and "VH-4150" which are manufactured by Dainippon Ink Chemicals, Ltd., and the like.

As a bisphenol type epoxy resin, there are products obtained by a reaction of bisphenols such as bisphenol A, bisphenol F, bisphenol S, and tetrabromobisphenol A with epichlorohydrin, and products obtained by reaction of a condensate A with epichlorohydrin. The condensate is obtained by diglycidylether of bisphenol A with the above-described bisphenols. As commercially supplied products thereof, there are "Epikote 1004" and "Epikote 1002" manufactured by Yuka Shell, Ltd., "DER-330" and "DER-337" which are manufactured by Dow Chemicals, Ltd., and the like.

Further, there can be also employed products obtained by reaction of phenols such as trisphenolmethane and tricresol methane with epichlorohydrin and/or methylepichlorohydrin, "EPPN-501" and "EPPN-502" manufactured by Nihon Kayaku, Ltd., which are commercially supplied products thereof and, further, tris(2,3-epoxypropyl)isocyanurate, biphenyldiglycidylether, and the like.

The epoxy resins may be employed solely or in combination of two or more kinds.

The epoxy compounds are preferably mixed in an amount of 0-100 parts by weight based on 100 parts by weight of the radiation-curable resin composition which comprises the (A'), the (B'), and the (C'). In the case that the amount of the epoxy compounds exceeds 100 parts by weight, characteristics of a high sensitivity decrease in the radiation-curable resin composition.

In the radiation-curable resin composition of the present invention, there can be optionally mixed a variety of additives, for example, extender pigments such as silica, talc, alumina, calcium carbonate, clay, and aerogel, coloring pigments such as Chromium Phthaloyellow and Cyanine Green, silicone-based and fluorine-based defoaming agents, leveling agents, and anti-oxidants, etc. It is to be noted that an epoxy compound can be also mixed as a thermosetting ingredient for the purpose of improvement of heat resistance in a cured layer.

The radiation-curable resin composition of the present invention comprises the modified copolymer (A'), thediluent (B'), and the photo-polymerization initiator (C'), as a mixing proportion thereof, (A') (solid component):(B') ranges in 30:70-70:30, and the component (C') is preferably mixed in an amount of 1-10 parts by weight based on 100 parts by weight of the total of the components (A') and (B'). The reason depends upon a well-balanced sensitivity and weatherability.

Further, in the case that the epoxy compound (D') is mixed, it is preferably mixed in an amount of 0-70 parts by weight based on 100 parts by weight of the total of the components (A') and (B'). Because, in the case of exceeding 70 parts by weight, sensitivity lowers.

### (Liquid-state resist)

The radiation-curable resin composition of the present invention can be employed as a liquid-state resist as it is.

The liquid-state resist is coated on a base plate in a desired thickness, and organic solvents are evaporated by heating at 60-80°C for 15-60 minutes. Subsequently, a desired pattern having transparent images is placed on the liquid-state resist coating layer over the base plate in a (contact) state, and the desired pattern is selectively exposed to light by irradiating an ultraviolet ray. In the liquid-state resist on an exposing region of the coating layer, bonds are alternately generated and changed to an insoluble state. Subsequently, non-exposed regions are removed by an aqueous alkali solution, whereby, the coating layer is developed. As a diluted aqueous alkali solution, there is usually employed a sodium carbonate solution having 0.5-5% by weight, and other alkalis can be also employed. In the case of supplying as an image-forming material, heat resistance is preferably improved by secondarily curing through irradiating an ultraviolet ray on a pattern obtained, or by heating at 100-200°C or irradiating a far infrared ray.

As radiations for curing the radiation-curable resin composition of the present invention, there can be employed rays such as a ray from a high pressure mercury lamp, an ultraviolet ray, an EB, and laser rays.

The modified copolymer of the present invention and the radiation-curable resin composition can be employed, in addition to the above descriptions, in many fields such as optical parts, a protecting film for a polarizing plate, electronics, an ultraviolet ray stabilizer for resins, coatings for decoration, insulating varnishes, an insulating sheet, an etching resist for a shadow mask, and a lamination board.

As the optical parts, there can be exemplified a lens and a protecting film, and the like. In the lens and the like obtained using the radiation-curable resin composition of the present invention, in addition to prevention of deterioration in resins, it is excellent in an effect for protecting eyes from an ultraviolet ray. Further, in the case that the radiation-curable resin composition of the present invention is employed for a polarizing plate, for example, a protecting film for an LCD, etc., there can be prevented deterioration of a liquid crystal by an ultraviolet ray.

Hereinafter, the fourth aspect of the present invention is illustrated by Examples.

### (Evaluation items)

### (IV-1) Ultraviolet ray absorption test

Absorption amount of ultraviolet ray at wave length of 400 nm was measured using a film having the thickness of 1 mm.
o : absorption ratio of not less than 85%,
x: absorption ratio of less than 85%

### (IV-2) Sensitivity

Sensitivity was evaluated using a 14-stages step tablet manufactured by Kodak.

### (IV-3) Alkali developability

Developability was evaluated according to the following standards using 1%-sodium carbonate.
o : Developable within 20 seconds
▲: Developable in 20-30 seconds
x: not less than 30 seconds

### (IV-4) Hardness

Pencil hardness was measured according to JIS Standard (K5400).

### (IV-5) Adhesion

Resist coating layer obtained was treated by boiled water for 1 hour, followed by carrying out a peeling test by a cellophane tape according to JIS D0202.
o : 100/100
▲: 50/100-99/100
x: 0/100-49/100

### (IV-6) Aqueous weak alkali resistance

Coating layer after exposed to light was immersed in a developer (1%-sodium carbonate) at 40°C for 30 minutes, and conditions of the coating layer were visually judged.
o : Nothing are any changes.
▲: Gloss of the coating layer slightly disappeared.
x: Gloss of the coating layer disappeared.

### (IV-7) Flexural resistance

Flexural resistance test was carried out using a flexural resistance tester according to JIS Standard, and cracks and peeling in a coating layer were visually observed.
o: nothing of any cracks and peeling
▲: slightly peeled
x: peeled

It is to be noted that diameter of an axle is 2 mm, and an aluminum plate treated by chromium phosphate was employed as a test plate.

### (Synthesis Example IV-1)

A 2-liter separable flask equipped with an agitator, a thermometer, a reflux condenser, a dropwise funnel, and a tube for supplying nitrogen was charged with 300 g of dipropyleneglycol monomethylether ("MFDG" manufactured by Nihon Nyukazai, Ltd.). After temperature was elevated to 105°C, there were collectively added dropwise 25 g of 2-(2'-hydroxy-5'-methacryloyloxyethyl phenyl)-2H-benzotriazol ("RUVA-93" manufactured by Otsuka Kagaku, Ltd.), 172 g of methacrylic acid, 101 g of methylmethacrylate (MMA), and 19.5 g of t-butyl-peroxy-2-ethylhexanoate ("Perbutyl O" manufactured by Nihon Yushi, Ltd.), and 200 g of MFDG over 3 hours. After the completion of dropwise addition, aging was conducted for 4 hours to prepare a trunk polymer having carboxylic groups. Subsequently, in a solution of the trunk polymer, there were added 202 g of 3,4-epoxycyclohexyl methylacrylate ("Cyclomer A200" manufactured by Daicel Chemical Industries, Ltd.), 2.0 g of triphenylphosphine, and 1.0 g of methylhydroquinone, followed by allowing to react at 100°C for 10 hours. Reaction was conducted in a mixed gas atmosphere of oxygen/nitrogen (10:90 volume %).

A modified copolymer obtained was designated as (IV-1). The modified copolymer (IV-1) contained 5% by weight of a compound (hereinafter, an ultraviolet ray absorbing body unit) having an unsaturated group and an ultraviolet ray-absorbable group, and it showed an acid value of 100 KOHmg/g, a double bond equivalent ("resin weight (shown by g) per 1 mol of an unsaturated group", hereinafter, the same) of 450, and a weight average molecular weight of 15,000.

### (Synthesis Example IV-2)

A 2-liter separable flask equipped with an agitator, a thermometer, a reflux condenser, a dropwise funnel, and a tube for supplying nitrogen was charged with 300 g of dipropyleneglycol monomethylether ("MFDG" manufactured by Nihon Nyukazai, Ltd.). After temperature was elevated to 105°C, there were collectively added dropwise 25 g of 2-(2'-hydroxy-5'-methacryloyloxyethyl phenyl)-2H-benzotriazol ("RUVA-93" manufactured by Otsuka Kagaku, Ltd.), 172 g of methacrylic acid, 145 g of methylmethacrylate (MMA), and 22.5 g of t-butyl-peroxy-2-ethylhexanoate ("Perbutyl O" manufactured by Nihon Yushi, Ltd.), and 200 g of MFDG over 3 hours. After the completion of dropwise addition, aging was conducted for 4 hours to prepare a trunk polymer having carboxylic groups. Subsequently, in a solution of the trunk polymer, there were added 158 g of glycidyl methylacrylate ("Blemmer G" manufactured by Toa Gosei, Ltd.), 1.6 g of triphenylphosphine, and 1.0 g of methylhydroquinone, followed by allowing to react at 100°C for 10 hours. Reaction was carried out in a mixed gas atmosphere of oxygen/nitrogen (10:90 volume %).

A modified copolymer obtained was designated as (IV-2). The modified copolymer (IV-2) contained 5% by weight of the ultraviolet ray absorbing body unit, and it showed an acid value of 100 KOHmg/g, a double bond equivalent of 450, and a weight average molecular weight of 24,000.

### (Synthesis Example IV-3)

A 2-liter separable flask equipped with an agitator, a thermometer, a reflux condenser, a dropwise funnel, and a tube for supplying nitrogen was charged with 375 g of dipropyleneglycol monomethylether ("MFDG" manufactured by Nihon Nyukazai, Ltd.). After temperature was elevated to 105°C, there were collectively added dropwise 36 g of 2-(2'-hydroxy-5'-methacryloyloxyethyl phenyl)-2H-benzotriazol ("RUVA-93" manufactured by Otsuka Kagaku, Ltd.), 200 g of methacrylic acid, 192 g of a succinic acid-modified compound ("FM-IA" manufactured by Daicel Chemical Industries, Ltd.) of a caprolactone-modified 2-hydroxyethylmethacrylate, and 28.0 g of t-butyl-peroxy-2-ethylhexanoate ("Perbutyl O" manufactured by Nihon Yushi, Ltd.), and 405 g of MFDG over 3 hours. After the completion of dropwise addition, aging was carried out for 4 hours to prepare a trunk polymer having carboxylic groups. Subsequently, in a solution of the trunk polymer, there were added 291 g of 3,4-epoxycyclohexyl methylacrylate ("Cyclomer A200" manufactured by Daicel Chemical Industries, Ltd.), 2.9 g of triphenylphosphine, and 1.5 g of methylhydroquinone, followed by allowing to react at 100°C for 10 hours. Reaction was carried out in a mixed gas atmosphere of oxygen/nitrogen (10:90 volume %).

A modified copolymer obtained was designated as (IV-3). The modified copolymer (IV-3) contained 5% by weight of the ultraviolet ray absorbing body unit, and it showed an acid value of 100 KOHmg/g, a double bond equivalent of 450, and a weight average molecular weight of 12,000.

### (Synthesis Example IV-4)

The same operations were followed as in the Synthesis Example IV-1 except that monomer proportion was altered to obtain a modified copolymer (IV-4). The modified copolymer (IV-4) contained 5% by weight of the ultraviolet ray absorbing body unit, and it showed an acid value of 50 KOHmg/g, a double bond equivalent of 450, and a weight average molecular weight of 15,000.

### (Synthesis Example IV-5)

The same operations were followed as in the Synthesis Example IV-1 except that monomer proportion was altered to obtain a modified copolymer (IV-5). The modified copolymer (IV-5) contained 5% by weight of the ultraviolet ray absorbing body unit, and it showed an acid value of 25 KOHmg/g, a double bond equivalent of 450, and a weight average molecular weight of 15,000.

### (Synthesis Example IV-6)

A 2-liter separable flask equipped with an agitator, a thermometer, a reflux condenser, a dropwise funnel, and a tube for supplying nitrogen was charged with 300 g of dipropyleneglycol monomethylether ("MFDG" manufactured by Nihon Nyukazai, Ltd.). After temperature was elevated to 105°C, there were collectively added dropwise 25 g of 2-(2'-hydroxy-5'-methacryloyloxyethyl phenyl)-2H-benzotriazol ("RUVA-93" manufactured by Otsuka Kagaku, Ltd.), 115 g of methacrylic acid, 158 g of butylacrylate (BA), and 19.5 g of t-butyl-peroxy-2-ethylhexanoate ("Perbutyl O" manufactured by Nihon Yushi, Ltd.), and 200 g of MFDG over 3 hours. After the completion of dropwise addition, aging was carried out for 4 hours to prepare a trunk polymer having carboxylic groups. Subsequently, in a solution of the trunk polymer, there were added 202 g of 3,4-epoxycyclohexyl methylacrylate ("Cyclomer A200" manufactured by Daicel Chemical Industries, Ltd.), 2.0 g of triphenylphosphine, and 1.0 g of methylhydroquinone, followed by allowing to react at 100°C for 10 hours. Reaction was conducted in a mixed gas atmosphere of oxygen/nitrogen (10:90 volume %).

A modified copolymer obtained was designated as (IV-6). The modified copolymer (IV-6) contained 5% by weight of the ultraviolet ray absorbing body unit) having an unsaturated group and an ultraviolet ray-absorbing body unit, and it showed an acid value of 25 KOHmg/g, a double bond equivalent of 450, and a weight average molecular weight of 15,000.

### (Synthesis Comparative Example IV-1)

A 2-liter separable flask equipped with an agitator, a thermometer, a reflux condenser, a dropwise funnel, and a tube for supplying nitrogen was charged with 300 g of dipropyleneglycol monomethylether ("MFDG" manufactured by Nihon Nyukazai, Ltd.) and 20 g of t-butyl-peroxy-2-ethylhexanoate ("Perbutyl O" manufactured by Nihon Yushi, Ltd.). After temperature was elevated to 95°C, there were collectively added dropwise 25 g of 2-(2'-hydroxy-5'-methacryloyloxyethyl phenyl)-2H-benzotriazol ("RUVA-93" manufactured by Otsuka Kagaku, Ltd.), 77 g of methacrylic acid, 398 g of methylmethacrylate, and 16.0 g of 2,2'-azobis(2-methylbutyronitrile) ("ABN-E manufactured by Nihon Hydrazine Kogyo, Ltd."), and 200 g of MFDG over 3 hours.

After the completion of dropwise addition, aging was carried out for 4 hours to prepare a modified copolymer (IV-7) having carboxylic groups.

The modified copolymer (IV-7) contained 5% by weight of the ultraviolet ray absorbing body unit, and it showed an acid value of 100 KOHmg/g, a double bond equivalent of 0, and a weight average molecular weight of 12,000. It is to be noted that reaction was conducted in an atmosphere of nitrogen.

### (Synthesis Comparative Example IV-2)

The same operations were followed as in the Synthesis Example IV-7 except that monomer proportion was altered to obtain a modified copolymer (IV-8). The modified copolymer (IV-8) contained 5% by weight of the ultraviolet ray absorbing body unit, and it showed an acid value of 25 KOHmg/g, a double bond equivalent of 0, and a weight average molecular weight of 12,000.

### [Examples IV-7-IV-11 and Comparative Example IV-3]

In relation to the respective modified copolymers, there was carried out an evaluation as an alkali-developable type image-forming material.

There were mixed 100 parts by weight (solid component) of the modified copolymer (IV-I), 40 parts by weight of dipentaerythritol hexaacrylate (DPHA), 20 parts by weight of a cresol-novolak type epoxy resin having an epoxy equivalent of 220 ("Epichlon N695" manufactured by Dainippon Ink, Ltd.), and "Irugacure 907" which is a photo-polymerization initiator, followed by kneading with a three-rolls kneader to obtain a viscous ink composition.

The ink composition was coated on a base plate on which patterns are formed in the thickness of 20-30 µm with a bar-coater, followed by drying with an air-circulating dryer at 80°C for 20 minutes.

Subsequently, a negative film was attached in contact with, followed by irradiating a dose of 1000 mJ/cm².

Further, development was carried out using 1%-aqueous solution of sodium carbonate, and a coating layer obtained was cured in an air-circulating oven at 150°C for 30 minutes to obtain a layer on which an image is formed. Likewise, as shown in Table IV-1, ink compositions and layers on which an image is formed were obtained in Examples IV-7-IV-11 and Comparative Example IV-3. In relation to the layers, there was carried out an evaluation of an ultra violet ray absorption test, sensitivity, alkali-developability, hardness, adhesion, and weak alkali solubility.

Results are shown in Table IV-1.

### [Examples IV-12-IV-14 and Comparative Examples IV-4 and IV-5]

There are shown examples of uses as a curing agent.

Coating agents according to formulations (part by weight) shown in Table IV-2 were coated on base plates which are an aluminum plate and a steel plate so that the thickness is adjusted to 10 µm, followed by curing in an air-circulating oven at 80°C for 20 minutes and by irradiating a dose of 1000 mJ/cm² with a high pressure mercury lamp. Further, curing was thermally carried out at 150°C for 30 minutes to form a cured coating layer. There were evaluated an ultra violet ray absorption test, sensitivity, hardness, and adhesion, etc. Results are shown in Table IV-2.

**Table IV-1**

| | Example | | | | | Comparative Example |
|---|---|---|---|---|---|---|
| | IV-7 | IV-8 | IV-9 | IV-10 | IV-11 | IV-3 |
| Modified copolymer IV-1 | 100 | | | | 50 | |
| Modified copolymer IV-2 | | 100 | | | | |
| Modified copolymer IV-3 | | | 100 | | | |
| Modified copolymer IV-4 | | | | 100 | 50 | |
| Modified copolymer IV-7 | | | | | | 100 |
| DPHA | 40 | 40 | 40 | 40 | 40 | 40 |
| Epichlon N695 | 20 | 20 | 20 | 20 | 20 | 20 |
| Irugacure 907 | 7 | 7 | 7 | 7 | 7 | 7 |

| Evaluation results | | | | | | |
|---|---|---|---|---|---|---|
| Ultra violet ray absorption test | o | o | o | o | o | o |
| Sensitivity | 2 | 3 | 4 | 3 | 3 | 2 |
| Alkali developability | o | o | o | ▲ | o | ▲ |
| Hardness | 4H | 4H | 2H | 4H | 4H | 2H |
| Adhesion | o | o | ▲ | o | o | x |
| Weak alkali solution solubility resistance | o | o | o | o | o | x |

**Table IV-2**

| | Example | | | Comparative Example | |
|---|---|---|---|---|---|
| | IV-12 | IV-13 | IV-14 | IV-4 | IV-5 |
| Modified copolymer IV-5 | 100 | | 100 | | |
| Modified copolymer IV-6 | | 100 | | | |
| Modified copolymer IV-8 | | | | 100 | 100 |
| CEL 2021P | 10 | 10 | 10 | 10 | 10 |
| PCL 308 | 0 | 0 | 10 | 0 | 10 |
| Irugacure 907 | 7 | 7 | 7 | 7 | 7 |

| Evaluation results | | | | | |
|---|---|---|---|---|---|
| Ultra violet ray absorption test | o | o | o | o | o |
| Sensitivity | 2 | 2 | 2 | - | - |
| Hardness | 4H | 4H | H | 2H | H |
| Flexural resistance | ▲ | o | o | x | o |
| Adhesion | o | o | o | ▲ | ▲ |
| Weak alkali solution solubility resistance | o | o | o | x | x |
| CEL 2021P: "Celloxide 2021 P" manufactured by Daicel Chemical Industries, Ltd. PCL 308: "Placcel 308: a polycaprolactone polyol" manufactured by Daicel Chemical Industries, Ltd. | | | | | |

### POSSIBILITY OF UTILIZATION IN INDUSTRY

The curable resin according to the first aspect of the present invention is very excellent in weatherability, and it is very useful as a constructing component for coatings, inks, and adhesives, and the like.

The process for the preparation of a modified copolymer according to the second aspect of the present invention is a useful technology by which there can be prepared a modified copolymer which is useful as a photo-curable resin in a short time, and which is very high in an industrial value.

The curable resin composition according to the third aspect of the present invention is very excellent in adhesion and weatherability. It does not contain solvents, and it is environmentally-friendly and, further, it is very useful as a constructing component for coatings, inks, and adhesives, and the like.

The radiation-curable resin composition according to the fourth of the present invention, in the case that it is employed as a liquid-state resist, is useful as a coating layer capable of absorbing an ultraviolet ray in which image patterns can be formed by developing with an alkali, and it was excellent in hardness, adhesion, and resistance against a weak alkali solution. Further, even in the case that it is employed as a curable coating layer, it was excellent in hardness, adhesion, and resistance against a weak alkali solution. The radiation-curable resin composition of the present invention is rich in processability, and it can be minutely processed by a radiation and, moreover, it is excellent in heat resistance and adhesion, and further, it is useful as an image-forming material and a coating material.

## Claims

1. A curable resin characterized by an acid value of not more than 20 KOH mg/g, said resin is obtained by addition of an epoxy group-containing unsaturated compound (c) having an alicyclic structure to carboxylic groups in a copolymer of a copolymerizable unsaturated carboxylic acid (a) with an unsaturated compound (b) other than the unsaturated carboxylic acid.

2. An outdoor coating which comprises the curable resin as claimed in claim 1.

3. A process for the preparation of a modified copolymer characterized in that a copolymer having carboxylic groups is obtained by copolymerization of a copolymerizable unsaturated carboxylic acid (a) with an unsaturated compound (b) other than the unsaturated carboxylic acid, and then, an epoxy group-containing unsaturated compound (c) is added to the carboxylic groups in the copolymer using a phosphine compound represented by general formula (II-1) described below as a catalyst for addition reaction, 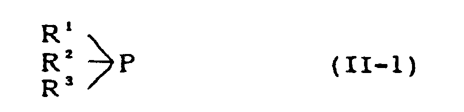 (in the formula, R¹ represents a phenyl group having an alkyl group or an alkoxy group and a linear or branched alkyl group or cycloalkoxy group, R² and R³ represent a phenyl group which may have an alkyl group or an alkoxy group and a linear or branched alkyl group or cycloalkyl group, and R¹, R², and R³ may be all different or identical, respectively).

4. A process for the preparation of a modified copolymer as claimed in claim 3, wherein said phosphine compound represented by the general formula (II-1) is any one of tricyclohexyl phosphine, tris(4-methylphenyl)phosphine, and tris(2,4,6-trimethoxyphenyl)phosphine.

5. A curable resin composition characterized by comprising the (A), (B), and (C) described below, and said composition does not substantially contain organic solvents,
(A) a modified copolymer in which an epoxy group-containing unsaturated compound (c) having an alicyclic structure is added to carboxyl groups in a copolymer of a copolymerizable unsaturated carboxylic acid (a) with an unsaturated compound (b) other than the unsaturated carboxylic acid,
(B) a reactive diluent having at least one (meth)acrylic groups, and,
(C) a polymerization initiator.

6. A modified copolymer in which an epoxy group-containing unsaturated compound (d') is added to carboxyl groups in a copolymer of a compound (a') having an unsaturated group and at least one carboxyl groups with a compound (b') having an unsaturated group and an ultraviolet ray-absorbable group.

7. A modified copolymer in which an epoxy group-containing unsaturated compound (d') is added to carboxyl groups in a copolymer of a compound (a') having an unsaturated group and at least one carboxyl groups with a compound (b') having an unsaturated group and an ultraviolet ray-absorbable group, and a (meth)acrylate (c').

8. A modified copolymer as claimed in claim 6 or 7 characterized in that a weight average molecular weight is 10,000-70,000.

9. A modified copolymer as claimed in claim 6 or 7 characterized by an acid value of 0-150.

10. A radiation-curable resin composition which comprises the following (A'), (B'), and (C'),
(A') a modified copolymer as claimed in any one of claims 6-9,
(B') a diluent, and
(C') a photo-polymerization initiator.

11. A radiation-curable resin composition which comprises the following (A'), (B'), (C'), and (D'),
(A') a modified copolymer as claimed in any one of claims 6-9,
(B') a diluent,
(C') a photo-polymerization initiator, and
(D') an epoxy compound.

12. A radiation-curable resin composition as claimed in claim 10 or 11, wherein said diluent is an unsaturated compound (e') having at least two methacryloyl groups or acryloyl groups.

13. A radiation-curable resin composition as claimed in claim 10 or 11, wherein said diluent is an unsaturated compound (f') having a boiling point of not less than 100°C at ordinary pressures and at least two ethylenic bonds

14. A liquid-state resist which comprises a radiation-curable resin composition as claimed in any one of claims 10-13.

15. An optical part which comprises curing a radiation-curable resin composition as claimed in any one of claims 10-13.

16. A protecting film for a polarizing plate which comprises curing a radiation-curable resin composition as claimed in any one of claims 10-13.
